# EUROPÄISCHE PATENTANMELDUNG

(11) **EP 0 785 707 A1**
(43) Veröffentlichungstag der Anmeldung: **23.07.1997**
(21) Anmeldenummer: 97100691.1
(22) Anmeldetag: 17.01.1997
(51) Int. Cl.: H05K 7/18

(54) **Aufsatz-Rahmen**

(30) Priorität: 19.01.1996 DE 19601888
(71) Anmelder: Schnitzenbaumer, Hubert, 83620 Feldkirchen-Westerham (DE)
(72) Erfinder: Schnitzenbaumer, Hubert, 83620 Feldkirchen-Westerham (DE)
(74) Vertreter: Alber, Norbert

(57) **Zusammenfassung**

Die Erfindung betrifft einen Aufsatz-Rahmen für Schaltkästen, Schalttableaus und Ähnliches mit einem umlaufenden Profil, mit dessen Hilfe der Deckel gegenüber dem Gehäuse des Schaltkastens einfach und sicher abdichtend befestigt werden kann, und unabhängig von der verwendeten Einbauvariante des Tableaus eine paßgenaue Fixierung des Deckels mit Hilfe des Aufsatzrahmens ermöglicht wird. Dabei weist das Profil (1) einen in die Tiefe des Schaltkastens weisenden Führungsschenkel (2) sowie einen dazu im wesentlichen parallelen, nach außen versetzten Außenschenkel (3) auf, welche in dem vorderen Bereich des Profils (1) über einen Verbindungsschenkel (4) U-förmig miteinander verbunden sind und dadurch eine von hinten her offene Einstecktasche (5) zwischen sich bilden.

## Beschreibung

Die Erfindung betrifft einen Aufsatz-Rahmen, wie er als vorderer Abschluß von Schaltkästen, Schalttableaus oder ähnlichen, vorzugsweise elektrischen Einrichtungen vorgesehen ist.

Dabei müssen in der Regel in einem solchen Schaltkasten oder Schalttableau elektrische Schaltelemente oder Anzeigeelemente innerhalb eines festen Kastens untergebracht und montiert werden, und dieser Kasten auf der Vorderseite in einen vorzugsweise leicht zu öffnenden Deckel untergebracht werden, in welchen in der Regel Schalter, Kontrollkästen oder Ähnliches angeordnet sind.

Derartige Schaltkästen oder Schalttableaus werden nach den jeweiligen Erfordernissen in den unterschiedlichsten Abmessungen hergestellt. Der Kasten des Gehäuses besteht dabei meist aus Stahlblech.

Zusätzlich werden diese Schaltkästen oder Tableaus in mehreren, vorzugsweise drei verschiedenen, Einbauvarianten genutzt:

Zum einen wird der Kasten auf eine feste Fläche wie eine Wand aufgeschraubt, von welcher er vollständig nach vorne abragt. Der andere Fall besteht darin, daß der Kasten beim Neubau eines Gebäudes in eine entsprechende Mauervertiefung eingelassen und dann beim Verputzen des Gebäudes mit eingeputzt wird.

Der dritte Anwendungsfall besteht darin, daß ein derartiger Schaltkasten in einer sogenannten Leichtbauwand, also einer Hohlwand mit äußeren Schichten aus festem Material, wie etwa hölzerner Spanplatte und dazwischen befindlichem losen Isoliermaterial, eingelassen und fixiert wird.

Es ist daher die Aufgabe der Erfindung, einen Aufsatzrahmen zu schaffen, mit dessen Hilfe der Deckel gegenüber dem Gehäuse des Schaltkastens einfach und sicher abdichtend befestigt werden kann, und unabhängig von der verwendeten Einbauvariante des Tableaus eine paßgenaue Fixierung des Deckels mit Hilfe des Aufsatzrahmens ermöglicht wird.

Diese Aufgabe wird durch die kennzeichnenden Merkmale des Anspruches 1 gelöst. Vorteilhafte Ausführungsformen ergeben sich aus den Unteransprüchen.

Durch den Aufbau des Aufsatzrahmens aus einem endlosen Profil, welches für den Umfang des Aufsatzrahmens in entsprechend lange, auf Gehrung geschnittene Profilteile geschnitten wird, ist es möglich, trotz Bevorratung nur einer einzigen Profilform in kurzer Zeit und mit sehr geringem Aufwand Aufsatzrahmen für jede gewünschte Form und Größe von Tableaus und Schaltkästen herzustellen.

Der weit nach hinten ragende Führungsschenkel dient dabei der Führung und auch Befestigung des Aufsatzrahmens an den Innenflächen des Gehäuses, in welche er in enger Anlage eingeschoben wird.

Wenn es sich dabei um ein aufputzmontiertes Gehäuse handelt, wird die freie Vorderkante des Gehäuses in die Einstecktasche zwischen dem Führungsschenkel und dem Außenschenkel eingeschoben, und im Falle einer dort vorher eingelegten Gehäusedichtung dazwischen eine Abdichtung vorgenommen. Die Fixierung erfolgt dadurch, daß im Gehäuse Gewindebohrungen vorhanden sind, die mit den Schlitzen im Führungsschenkel fluchten. Durch Einschrauben von Schrauben und deren Festziehen werden die Wand des Gehäuses und der Führungsschenkel des Aufsatzrahmens an mehreren Stellen miteinander verklemmt und fixiert.

Wegen der Längserstreckung der Schlitze ist es dabei möglich, den Aufsatzrahmen entweder bis zum Anschlag der Vorderkante des Gehäuses in der Einstecktasche einzuschieben, oder nur ein teilweises Einschieben in die Einstecktasche zu bewirken. Dies ist bei Aufputzmontage dann sinnvoll, wenn wider Erwarten im Inneren des Gehäuses mehr Einbautiefe für die unterzubringenden elektrischen Elemente benötigt wird als ursprünglich erwartet.

Der häufigste Fall für die Benutzung dieser Ausgleichsfunktion besteht jedoch darin, daß bei einem eingeputzten Gehäuse die Gehäusevorderkante nicht vollständig mit der Putzoberfläche fluchtet, also darüber an den unterschiedlichen Seiten unterschiedlich weit vorsteht oder gar hinter der Putzoberfläche zurücksteht, aufgrund der Ungenauigkeiten bei den Verputzarbeiten.

Um dennoch ein planes Montieren des Aufsatzrahmens und des ihn tragenden Deckels bezüglich der Wandoberfläche sicherzustellen, wird der Aufsatzrahmen mit den langen Führungsschenkeln des Profils wieder ins Innere des Gehäuses eingeschoben. Dabei können sich die Vorderkanten des Gehäuses teilweise in die Einstecktasche zwischen dem Außenschenkel und dem Führungsschenkel hineinerstrecken, und zwar auf unterschiedlichen Seiten des Gehäuses z. B. unterschiedlich weit hineinerstrecken bei schiefer Montage des Gehäuses in der Wand, oder das Gehäuse steckt mit seinen Vorderkanten überhaupt nicht mehr in der Einstecktasche, sondern das Profil liegt mit dem hinteren Ende der kürzeren Außenschenkel auf der Wandoberfläche an, während eine Verbindung zwischen Profil und Gehäuse nur über die gehäuseumlaufenden Führungsschenkel erfolgt.

Ein derartiges, beispielsweise aus Aluminium-Strangguß hergestelltes Profil hält bei ausreichender Dimensionierung (z. B. 2-3 mm Wandstärke) den üblichen Belastungen ohne weiteres stand. Für das schräge Aufschieben des aus einem solchen Profil bestehenden Aufsatzrahmen auf das Gehäuse ist einerseits eine Breite der Einstecktasche erforderlich, die größer ist als die Wanddicke des Gehäuses, und andererseits sind die Außenkanten des hinteren Endes des langen Führungsschenkels für ein leichtes Einschieben in das Gehäuse vorzugsweise angeschrägt.

Um eine in die Einstecktasche eingelegte Gehäusedichtung dort ohne Kleber etc. vor der Montage sicher zu fixieren, ist die Einstecktasche vorzugsweise mit einem Hinterschnitt in ihrem tiefsten Bereich ausgestattet. Um bei sehr schräger Einführung der Führungsschenkel des Profils, aus welchem der Aufsatzrahmen besteht, sogar ein Verbiegen des Führungsschenkels in das Innere des Gehäuses hinein zuzulassen, sind an den Innenflächen der Führungsschenkel wenigstens eine, vorzugsweise mehrere parallel laufende, Rillen angeordnet, die den Querschnitt des Führungsschenkels soweit reduzieren, daß ein leichteres Verbiegen möglich ist. Diese Rillen sind vorzugsweise vorderhalb der vorderen Enden der Schlitze im Führungsschenkel angeordnet, und hinterhalb eines Querschenkels, der vom Führungsschenkel in das Innere des Aufsatzrahmens, also vom Außenschenkel weg, weist. Dieser Querschenkel dient zur Anlage des Deckels, welcher vor dem Querschenkel im Aufsatzrahmen durch entsprechende Scharnierbohrungen oder auf andere bekannte Weise befestigt wird.

Zu diesem Zweck ist am Übergang zwischen dem Querschenkel und dem vorderen Bereich des Führungsschenkels eine Nut angeordnet, die zum Einlegen einer umlaufenden, vorzugsweise einstückigen, Deckeldichtung dient, an welcher der geschlossene Deckel somit dicht anliegt und den Bereich vor dem Deckel wassergeschützt von dem dahinter liegenden Bereich abtrennt. Um eine sichere Fixierung der Deckeldichtung zu erleichtern, ist diese Nut vorzugsweise ebenfalls mit einem Hinterschnitt ausgestattet, und hat insbesondere eine Kreisform, und aufgrund der Anordnung in einem 90°-Innenwinkel die Form eines Dreiviertel-Kreises.

Dieser Querschenkel dient jedoch nicht nur sowohl der Anlage des Deckels als auch der zusätzlichen Versteifung des Profils, insbesondere dessen Führungsschenkel, sondern gleichzeitig auch zur Befestigung der einzelnen Stücke der Profile zu einem geschlossenen Aufsatzrahmen, indem die Rückseite dieses Querschenkels zum Anordnen und nach der Montage für den Benutzer unsichtbaren Befestigungsteilen benutzt wird, beispielsweise verschraubte Winkel, die in den auf Gehrung geschnittenen Anschlüssen der einzelnen Profilteile aneinander auf der Rückseite des Querschenkels aufgeschraubt werden.

In einer bevorzugten Ausführungsform ist in der Rückseite des Querschenkels eine hinterschnittene Nut angeordnet, in welche derartige Verschraubungswinkel mit ihren freien Enden jeweils eingeschoben und mittels Klemmschrauben verklemmt werden können, beispielsweise eine sogenannte T-Nut. Dadurch ist jedes rechtwinklige Gehäuse auf einfache Art und Weise mit einem erfindungsgemäßen Aufsatzrahmen abzudecken, wofür lediglich eine einzige Profilform und eine einzige Art von Verbindungswinkeln bevorratet werden muß.

Eine Ausführungsform gemäß der Erfindung ist im folgenden anhand der Figuren beispielhaft näher beschrieben. Es zeigen:
- Fig. 1:: eine Schnittdarstellung durch einen aus Profilen 1 hergestellten Aufsatzrahmen und
- Fig. 2:: den Aufsatzrahmen gemäß Fig. 1 in der Aufsicht von oben.

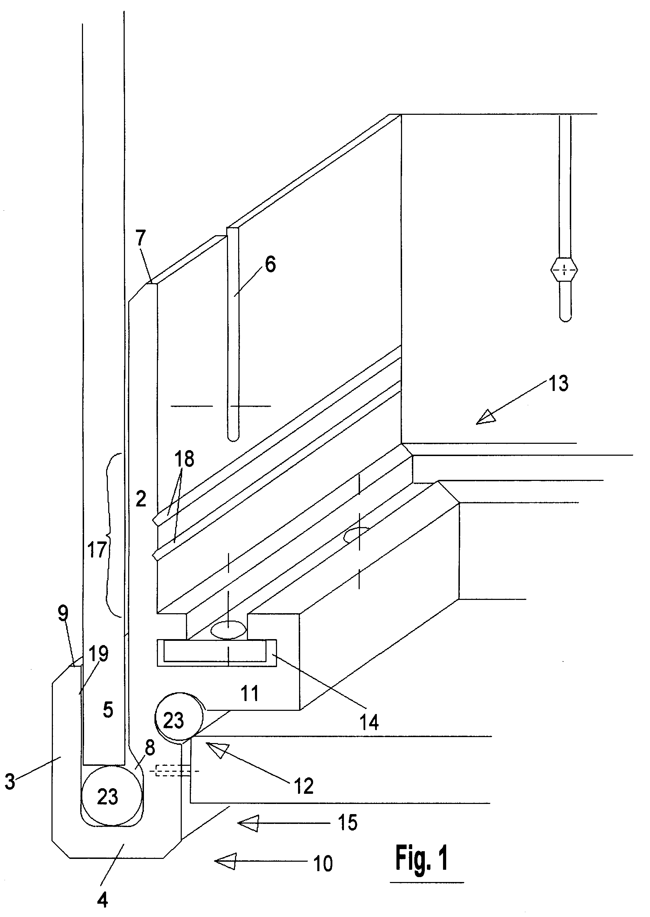

In Fig. 1 ist vor allem die Form des Profils zu erkennen, aus welchem der Aufsatzrahmen gemäß der Erfindung besteht.

Dabei ist zu erkennen, daß sich ein relativ langer Führungsschenkel 2 auf der Innenseite anliegend in das Gehäuse hinein erstreckt, und parallel zum Führungsschenkel 2 ein kürzerer Außenschenkel 3 verläuft, die in ihrem vorderen Bereich über einen Verbindungsschenkel 4 U-förmig miteinander verbunden sind. Zur Justierung der Eintauchtiefe des Profils 1 in das Gehäuse können die in die Gehäusewand 19 eingeschraubten Gehäuseschrauben 20 entlang der Schlitze 6, die von der Hinterkante 7 des Führungsschenkels 2 nach vorne ragen, vor dem Festziehen verschoben werden, so daß unabhängig vom vorliegenden Montagefall des Gehäuses immer eine technisch und optisch einwandfreie Positionierung des Außenrahmens gegenüber dem Gehäuse möglich ist.

Dabei kann die Gehäusewand 19 teilweise oder ganz in die durch den Abstand zwischen Führungsschenkel und Außenschenkel gebildete Einstecktasche eintauchen, und stützt sich dort vorzugsweise gegenüber der im Grund der Eintauchtasche 5 befindlichen Gehäusedichtung 23 ab.

Die Vorderkanten des Profils 1, also in der Regel die Vorderkante des Verbindungsschenkels 4, sofern der Außenschenkel und der Führungsschenkel nicht nach vorne über diesen Verbindungsschenkel 4 hinausragen, sind dabei gerundet oder abgeschrägt, und ebenfalls die außenliegende Kante des hinteren Endes 9 des Außenschenkels 3. Die Außenkante 7a der Hinterkante 7 des Führungsschenkels 2 ist vorzugsweise immer abgeschrägt und nicht gerundet, da hierdurch bei knappem Sitz das Einschieben des Aufsatzrahmens in das kastenförmige Gehäuse erleichtert wird.

Etwa am Übergang vom vorderen zum mittleren Drittel des Führungsschenkels 2 ragt von diesem im 90°-Winkel abstrebend der Querschenkel 11 vom Außenschenkel 3 wegragend in das Innere des Aufsatzrahmens. Der Querschenkel 11 dient auf der Vorderseite als Anlage für den Deckel 16 und auf der Rückseite für das Verbinden der einzelnen Profilstücke 1a, 1b untereinander zu einem geschlossenen Aufsatzrahmen.

Zu diesem Zweck ist auf der Vorderseite des Querschenkels 11 in dessen Innenkante am Übergang zum Führungsschenkel 2 eine vorzugsweise hinterschnittene, insbesondere kreisförmig profilierte Nut 12 ausgebildet, in welche eine Deckeldichtung 22 eingelegt ist, an welcher der Deckel 16 im geschlossenen Zustand dicht anliegt.

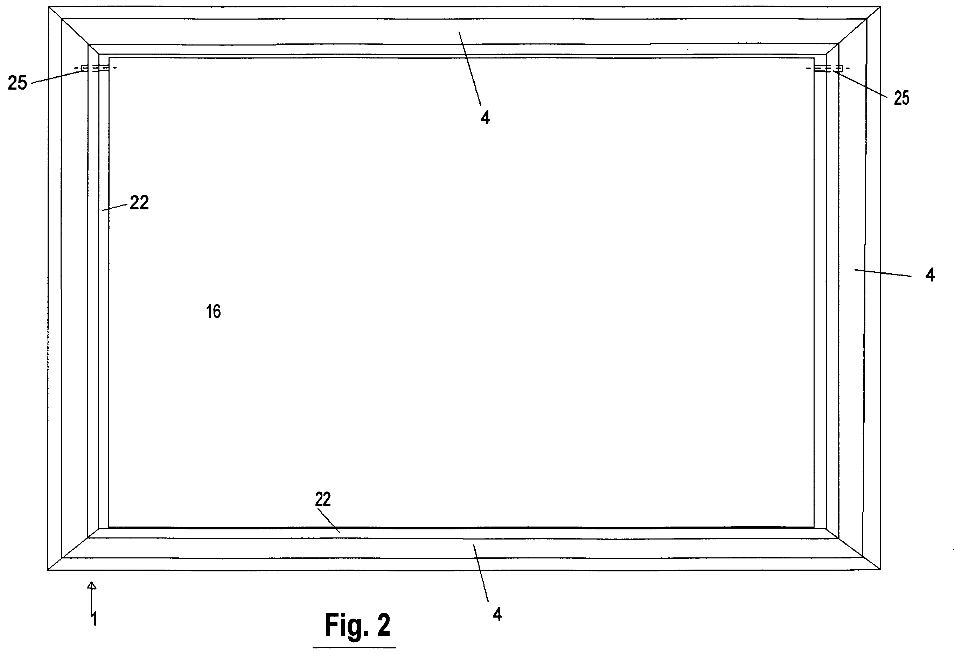

Wie besser in Fig. 2 zu erkennen, ist der Deckel 16 über in dem vorderen Bereich des Führungsschenkels 2 angeordnete Scharniere bzw. Scharnierbohrungen 25 im Aufsatzrahmen schwenkbar gelagert.

Auf der Rückseite des Querschenkels 11 ist in dieser eine hinterschnittene Verbindungsnut 14 in Form einer T-Nut angeordnet. Aufgrund des Zuschnittes der Profilstücke 1a, 1b auf Gehrung und der Wahl von Eckenwinkeln 21, deren Querschnitt in den Hinterschnitt dieser Verbindungsnut 14 paßt, können die einzelnen Profilstücke 1a, 1b bei der Montage jeweils auf die freien Enden der Eckenwinkel 21 aufgeschoben werden bis zur Anlage in der Gehrung aneinander, und anschließend werden lediglich die durch die Gewindebohrungen der Eckenwinkel von hinten her hindurch geschraubten Klemmschrauben 24 festgezogen, die sich mit ihrer vorderen Stirnfläche am Boden der Verbindungsnut 14 abstützen, und damit einerseits den Eckenwinkel 21 über die beiden angrenzenden Profilstücken 1a, 1b verklemmen und damit diese beiden Profilstücke 1a, 1b fest miteinander verbinden.

Im Bereich knapp hinter dem Querschenkel 11 sind ferner die Rillen 18 auf der Innenseite des Führungsschenkels 2 zu erkennen, die dessen Querschnitt geringfügig schwächen, so daß ggf. ein leichteres Umbiegen des Führungsschenkels 2 nach innen bei schrägem Einsatz in ein Gehäuse möglich ist.

Dabei ragt die Verbindungsnut 14 des Querschenkels 11 nicht soweit nach außen, daß der Querschnitt des Führungsschenkels 2 dadurch geschwächt würde. insbesondere ragen die Verbindungsnut 14 und die Nut 12 für die Deckeldichtung 22 in etwa gleich weit nach außen, so daß eine durchgängig erhaltene Dicke des Führungsschenkels 2 in dessen hinteren beiden Dritteln erhalten wird.

Im vorderen Drittel kann die Dicke des Führungsschenkels 2 demgegenüber deutlich größer sein, indem die in das Innere des Aufsatzrahmens hineingerichtete Seitenfläche des Führungsschenkels 2 in diesem vorderen Bereich weiter innen liegt als in dem hinter dem Querschenkel 11 liegenden hinteren Bereich, was insbesondere zum Anbringen der Scharnierbohrungen 25 sinnvoll ist und für die Stabilisierung des Profils im vorderen Bereich.

### BEZUGSZEICHENLISTE

- 1: Profil
- 1a, 1b: Profilstücke
- 2: Führungsschenkel
- 3: Außenschenkel
- 4: Verbindungsschenkel
- 5: Einstecktasche
- 6: Schlitze
- 7: Hinterkante
- 7a: Außenkante
- 8: Hinterschnitt
- 9: hinteres Ende
- 10: vorderes Ende
- 11: Querschenkel
- 12: Nut
- 13: Rückseite
- 14: Verbindungsnut
- 15: Frontbereich
- 16: Deckel
- 17: Bereich
- 18: Rille
- 19: Gehäusewand
- 20: Gehäuseschraube
- 21: Eckenwinkel
- 22: Deckeldichtung
- 23: Gehäusedichtung
- 24: Klemmschraube
- 25: Scharnierbohrungen

## Patentansprüche

1. Aufsatz-Rahmen für Schaltkästen, Schalttableaus und Ähnliches mit einem umlaufenden Profil (1),
**dadurch gekennzeichnet, daß**
das Profil (1) einen in die Tiefe des Schaltkastens weisenden Führungsschenkel (2) sowie einen dazu im wesentlichen parallelen, nach außen versetzten Außenschenkel (3) aufweist, welche in dem vorderen Bereich des Profils (1) über einen Verbindungsschenkel (4) U-förmig miteinander verbunden sind und dadurch eine von hinten her offene Einstecktasche (5) zwischen sich bilden.

2. Aufsatz-Rahmen nach Anspruch 1,
**dadurch gekennzeichnet, daß**
der Außenschenkel (3) kürzer ist als der Führungsschenkel (2).

3. Aufsatz-Rahmen nach einem der vorhergehenden Ansprüche,
**dadurch gekennzeichnet, daß**
im hinteren Bereich des Führungsschenkels (2) von der Hinterkante (7) des Führungsschenkels (2) im rechten Winkel nach vorne ragende Schlitze (6) angeordnet sind.

4. Aufsatz-Rahmen nach einem der vorhergehenden Ansprüche,
**dadurch gekennzeichnet, daß**
die Einstecktasche (5) in ihrem tiefsten Bereich einen Hinterschnitt (8) aufweist.

5. Aufsatz-Rahmen nach einem der vorhergehenden Ansprüche,
**dadurch gekennzeichnet, daß**
das hintere Ende (9) des Außenschenkels (3) eine quer zur Längserstreckung des Außenschenkels (3) verlaufende Anschlagfläche aufweist.

6. Aufsatz-Rahmen nach Anspruch 5,
**dadurch gekennzeichnet, daß**
von dem Führungsschenkel (2), zurückversetzt vom vorderen Ende (10) des Profils (1), ein Querschenkel (11) im wesentlichen rechtwinklig vom Führungsschenkel (2) in die vom Außenschenkel (3) wegweisende Richtung abstrebt, und
auf der Rückseite (13) des Querschenkels (11) eine hinterschnittene Verbindungsnut (14) angeordnet ist.

7. Aufsatz-Rahmen nach Anspruch 6,
**dadurch gekennzeichnet, daß**
im Innenwinkel (12) zwischen der Vorderseite des Querschenkels (11) und dem Führungsschenkel (2) eine Nut (12) ausgebildet ist, und
die Nut (12) eine hinterschnittene Nut ist.

8. Aufsatz-Rahmen nach Anspruch 7,
**dadurch gekennzeichnet, daß**
die Nut (12) einen Querschnitt in Form eines Dreiviertel-Kreises aufweist.

9. Aufsatz-Rahmen nach einem der vorhergehenden Ansprüche,
**dadurch gekennzeichnet, daß**
die Verbindungsnut (14) so angeordnet ist, daß dadurch der Querschnitt des Führungsschenkels (2) nicht geschwächt wird.

10. Aufsatz-Rahmen nach einem der vorhergehenden Ansprüche,
**dadurch gekennzeichnet, daß**
der Aufsatz-Rahmen aus mehreren auf Gehrung geschnittenen Stücken des Profils (1) besteht, welche durch Einschieben von Winkelstücken in die aneinander angrenzenden Hinterschnitte der Verbindungsnuten (14) und dortiges Verschrauben miteinander fest verbunden sind.

11. Aufsatz-Rahmen nach einem der vorhergehenden Ansprüche,
**dadurch gekennzeichnet, daß**
in die Nut (12) eine umlaufende, vorzugsweise endlose, Deckeldichtung (22) eingelegt ist und zwischen zwei einander gegenüberliegenden, vom Querschenkel (11) nach vorne ragenden, Frontbereichen (15) der Führungsschenkel (2) wenigstens ein Deckel (16) schwenkbar im Aufsatzrahmen gelagert ist, welcher im geschlossenen Zustand dicht an der Deckeldichtung (22) anliegt, so daß der Bereich hinter dem Aufsatzrahmen gegenüber dem davorliegenden Bereich wassergeschützt ist.

12. Aufsatz-Rahmen nach einem der vorhergehenden Ansprüche,
**dadurch gekennzeichnet, daß**
in der Einstecktasche (5) bzw. deren Hinterschnitt eine vorzugsweise endlose Gehäusedichtung (23) eingelegt ist.

13. Aufsatz-Rahmen nach einem der vorhergehenden Ansprüche,
**dadurch gekennzeichnet, daß**
die Schlitze (6) von der Hinterkante (7) des Führungsschenkels (2) aus den Querschenkel (11) nicht erreichen und im dazwischen verbleibenden Bereich (17) auf der Innenseite des Aufsatzrahmens in den dem Führungsschenkel (2) wenigstens eine, vorzugsweise mehrere parallel laufende, Rillen (18) ausgebildet sind.
